# EUROPÄISCHE PATENTSCHRIFT

(11) **EP 3 408 865 B1**
(45) Veröffentlichungstag und Bekanntmachung des Hinweises auf die Patenterteilung: **26.01.2022**
(21) Anmeldenummer: 17707230.3
(22) Anmeldetag: 22.02.2017
(51) Int. Cl.: H01L 31/02, H01L 25/16, H01L 31/0203, H01L 31/0232, H01L 31/167

(54) **BAUELEMENTTRÄGER MIT KONTAKTKAMMERN FÜR EINE OPTOELEKTRONISCHE VORRICHTUNG**
DEVICE CARRIER COMPRISING CONTACT CHAMBERS FOR AN OPTOELECTRONIC APPARATUS
SUPPORT DE COMPOSANTS COMPRENANT CHAMBRES DE CONTACT DESTINÉ À UN DISPOSITIF OPTOÉLECTRONIQUE

(30) Priorität: 23.02.2016 DE 102016103136
(43) Veröffentlichungstag der Anmeldung: 05.12.2018
(73) Patentinhaber: Vishay Semiconductor GmbH, 74072 Heilbronn (DE)
(72) Erfinder: BURGER, Daniel, 74211 Leingarten (DE); KUHN, Sascha, 74229 Oedheim (DE); MÜHLECK, Peter, 74254 Offenau (DE)
(74) Vertreter: Manitz Finsterwald Patent- und Rechtsanwaltspartnerschaft mbB
(86) Internationale Anmeldenummer: PCT/EP2017/054075
(87) Internationale Veröffentlichungsnummer: WO 2017/144538

(56) Entgegenhaltungen:
- EP-A1- 2 829 918
- EP-A2- 2 381 474
- DE-A1- 10 241 934
- JP-A- 2004 200 593
- US-A1- 2012 080 674
- US-A1- 2015 034 804

## Beschreibung

Die vorliegende Erfindung betrifft eine optoelektronische Vorrichtung mit einer Trägereinrichtung. Die Trägereinrichtung ist dazu vorgesehen, die für einen anwendungsgemäßen Betrieb der Vorrichtung benötigten elektronischen Bauelemente bzw. Einheiten, insbesondere einen optoelektronischen Sender und/oder Empfänger, aufzunehmen und elektrisch zu kontaktieren.

Oberhalb der Trägereinrichtung, d.h. bezüglich einer Vertikalrichtung oberhalb eines optoelektronischen Senders und/oder Empfängers, kann ein Linsenelement vorgesehen sein, welches wenigstens einen Linsenabschnitt für einen optoelektronischen Sender und/oder optoelektronischen Empfänger aufweist. Hierfür kann der jeweilige Linsenabschnitt strahlformende und/oder strahlumlenkende Eigenschaften aufweisen.

Derartige optoelektronische Vorrichtungen sind insbesondere als optoelektronische Sensorvorrichtungen ausgebildet, um Eigenschaften von Objekten optisch abtasten und elektronisch erfassen zu können. Ein Anwendungsfall für solche Sensorvorrichtungen liegt im Bereich von kommerziell erhältlichen Druckergeräten, d.h. Vorrichtungen zum computergestützten Bedrucken von Papier mittels bekannter Drucktechnologien, z.B. der Laserdruck- oder Tintenstrahldrucktechnologie. Um einen möglichst vollautomatischen und benutzerfreundlichen Betrieb eines Druckers (oder eines einen Drucker umfassenden Multifunktionsgeräts) zu ermöglichen, müssen verschiedene Betriebsparameter des Druckers, wie etwa eine Menge oder ein Typ des in ein Aufnahmefach des Druckers eingelegten Papiers, ein vorgesehenes Papierformat, die relative Position einer Papierkante und dergleichen ermittelt und gegebenenfalls überwacht werden. Ferner besteht Bedarf an einer automatischen Analyse eines jeweiligen Druckergebnisses oder eines zu scannenden Papiers, um z.B. den Inhaltstyp (Bild vs. Text) des zu scannenden Papiers oder die korrekte Konfigurierung (z.B. mechanische Ausrichtung einer Druckeinheit des Druckers) anhand eines Druckergebnisses zu überprüfen.

Typischerweise ist für jeden zu messenden Betriebsparameter eine individuell angepasste optoelektronische Vorrichtung vorgesehen, welche dazu ausgebildet ist, ein emittiertes optisches Signal mit einem detektierten, z.B. reflektierten optischen Signal zu vergleichen, um aus der Differenz dieser optischen Signale den betreffenden Betriebsparameter bestimmen können. Bei den optischen Signalen handelt es sich im Allgemeinen um elektromagnetische Strahlung einer sichtbaren oder unsichtbaren Wellenlänge, insbesondere Infrarot. Häufig umfasst die Vorrichtung sowohl einen optoelektronischen Sender als auch (wenigstens) einen optoelektronischen Empfänger. So kann die Vorrichtung beispielsweise als Näherungssensor fungieren. Es sind aber auch Varianten möglich, in denen eine optoelektronische Vorrichtung lediglich einen optoelektronischen Sender oder lediglich einen optoelektronischen Empfänger (für eine passive Detektion) aufweist. Ferner sind Vorrichtungen mit mehreren Sendern und Empfängern möglich, wobei eine Vorrichtung z.B. mehrere Betriebsparameter insbesondere zeitgleich bestimmen kann (z.B. mit einer Unterscheidung zwischen diffuser und spiegelnder Reflexion).

Aufgrund der Vielzahl zu messender Betriebsparameter ist eine entsprechende Vielfalt von optoelektronischen Vorrichtungen erforderlich, was mit einem unerwünschten Kostenaufwand in der Herstellung und Lagerhaltung verbunden ist. Ferner muss eine optotelektronische Vorrichtung zur Messung eines jeweiligen Betriebsparameters eine spezifische Trägereinrichtung aufweisen, die in Abhängigkeit von dem betreffenden Betriebsparameter sehr unterschiedlich sein kann und diesbezüglich einen hohen Entwicklungsaufwand erfordert. Beispielsweise muss die Trägereinrichtung an die optoelektronischen Bauelemente angepasst werden. So müssen etwa der geometrische Entwurf der Trägereinrichtung sowie die Aufteilung von Kontaktierungsflächen derselben in Abhängigkeit der jeweils erforderlichen Position der betreffenden Bauelemente relativ zu einem oberhalb der Trägereinrichtung angeordneten Linsenelement erfolgen. Häufig sind die zu installierenden Bauelemente, insbesondere aber auch die Anzahl der Bauelemente, sehr unterschiedlich, was den Anpassungsaufwand im Hinblick auf die Trägereinrichtung weiter erhöht.

Die Druckschrift EP 2 381 474 A2 zeigt einen Leiterrahmen der mittels Spritzgussverfahren aufgebrachte reflektierende Kavitäten zur Aufnahme von Licht emittierenden Halbleiterchips aufweist.

Die Druckschrift JP 2004 200593 A zeigt einen mit Kunststoff umspritzten Leiterrahmen mit Öffnungen, wobei in einer Öffnung ein Licht emittierendes Element und in einer weiteren Öffnung ein Licht empfangendes Bauelement auf dem Leiterrahmen angebracht ist.

Die Druckschrift EP 2 829 918 A1 zeigt einen Sensor mit einer Leiterplatte. Ein Lichtemitter und ein Lichtempfänger sind auf der Leiterplatte oberflächenmontiert. Eine Sensorabdeckung ist mit der Leiterplatte verbunden und eine Licht abschirmende Wand befindet sich zwischen Sender und Empfänger.

Die Druckschrift DE 102 41 934 A1 zeigt einen optischen Sensor mit einer Leiterplatte. Die Leiterplatte weist Photodioden und Licht emittierenden Dioden auf, wobei die Halbleiterchips für die Photodioden und die Dioden direkt auf die Platine gelötet und drahtgebondet sind.

Es ist eine Aufgabe der Erfindung, eine Trägereinrichtung zu schaffen, die einfach und variabel mit unterschiedlichen optoelektronischen Bauelementen bestückt werden kann, um eine an eine individuelle Anwendung angepasste optoelektronische Vorrichtung herstellen zu können, ohne dass jedoch die Trägereinrichtung hierfür verändert werden muss.

Die Aufgabe wird gelöst durch eine Trägereinrichtung für eine optoelektronische Vorrichtung mit den Merkmalen des Anspruchs 1.

Eine Trägereinrichtung für eine optoelektronische Vorrichtung weist eine Längserstreckung und eine Quererstreckung auf, wobei die Trägereinrichtung mehrere parallel zu der Längserstreckung ausgerichtete elektrisch leitende Kontaktbahnen aufweist, wobei die Trägereinrichtung an einer Oberseite mehrere parallel zu der Quererstreckung ausgerichtete Kontaktkammern aufweist. Jede der Kontaktbahnen ist in jeder der Kontaktkammern elektrisch kontaktierbar, so dass in einer variablen Bestückung wenigstens ein optoelektronischer Sender und/oder wenigstens ein optoelektronischer Empfänger in der jeweiligen Kontaktkammer installiert werden kann.

Die Trägereinrichtung der optoelektronischen Vorrichtung ist in zueinander unterschiedlichen Richtungen in mehrere elektrisch leitende Kontaktbahnen und mehrere Kontaktkammern unterteilt, um die Trägereinrichtung individuell mit optoelektronischen Bauelementen bzw. Einheiten bestücken zu können und um die optoelektronischen Bauelemente individuell elektrisch kontaktieren zu können. Die Kontakt bahnen sind entlang der Quererstreckung der Trägereinrichtung voneinander getrennt und somit elektrisch voneinander isoliert. Jede der Kontaktbahnen liegt in jeder der Kontaktkammern zumindest abschnittsweise frei oder ist in sonstiger Weise zugänglich, um ein elektrisches Kontaktieren zu ermöglichen.

Die Unterteilung in mehrere Kontaktkammern ermöglicht ein optisches Isolieren der optoelektronischen Bauelemente, um ein optisches Übersprechen zu verhindern. Die Kontaktkammern sind entlang der Längserstreckung der Trägereinrichtung voneinander getrennt bzw. abgegrenzt und vorzugsweise umfänglich umgrenzt, jedoch an der Oberseite offen. Jede der Kontaktkammern stellt einen zumindest funktional einheitlichen Installationsbereich der Trägereinrichtung dar, sodass die Trägereinrichtung auf einfache und flexible Weise mit mehreren optoelektronischen Bauelementen bestückt werden kann, welche insbesondere unabhängig voneinander betrieben werden können. Ein besonderer Vorteil der Erfindung liegt darin, dass in jeder der genannten mehreren Kontaktkammern jede der genannten mehreren Kontaktbahnen elektrisch kontaktierbar ist. Die Flexibilität der Bestückung ist hierdurch besonders hoch. Einerseits kann ein in einer jeweiligen Kontaktkammer zu installierendes Bauelement lokal flexibel mit einer oder mehreren der Kontaktbahnen verbunden werden, wobei hierfür keine größeren Entfernungen, insbesondere zwischen benachbarten Kontaktkammern, überbrückt werden müssen. Ferner kann die Position eines zu installierenden Bauelements flexibel gewählt werden, da das Bauelement prinzipiell in jeder Kontaktkammer gleichermaßen gut installiert werden kann. Somit ist die Trägereinrichtung für nahezu beliebige Bestückungstopologien geeignet und somit universell einsetzbar. Eine Anpassung der Trägereinrichtung an eine gewünschte Bestückungstopologie ist hierbei nicht erforderlich. Die gleiche Trägereinrichtung kann somit dazu verwendet werden, um die optoelektronische Vorrichtung an vielfältige individuelle Anwendungen anzupassen.

Im Zusammenhang mit der Erfindung ist unter einem optoelektronischen Bauelement bzw. einer optoelektronischen Einheit insbesondere eine optoelektronischer Sender und/oder ein optoelektronischer Empfänger zu verstehen.

Die Anzahl der Kontaktkammern kann an die für die optoelektronische Vorrichtung vorgesehenen Anwendungsfälle angepasst sein. Vorzugsweise sind mehrere gleichartig ausgebildete Kontaktkammern insbesondere in Längsrichtung der optoelektronischen Vorrichtung hintereinander angeordnet. Einzelne oder mehrere Kontaktkammern können aber auch unterschiedlich ausgebildet sein. Beispielsweise kann eine Kontaktkammer größer als die anderen ausgebildet sein, um mehrere oder größere elektronische Bauelemente in der vergrößerten Kontaktkammer installieren zu können.

Die Trägereinrichtung weist drei, vier, fünf oder sechs Kontaktbahnen auf.

Entsprechend kann die Trägereinrichtung beispielsweise drei, vier, fünf oder sechs Kontaktkammern aufweisen. In besonderen Anwendungsfällen sind auch mehr als sechs Kontaktbahnen und/oder Kontaktkammern pro Trägereinrichtung möglich. Hierbei kann die Anzahl der Kontaktbahnen der Anzahl der Kontaktkammern entsprechen oder sich höchstens um die Anzahl Eins oder höchstens um die Anzahl Zwei unterscheiden. Eine mit der Anzahl der Kontaktbahnen korrespondierende Anzahl von Kontaktkammern ist generell vorteilhaft, da die Trägereinrichtung hierdurch besonders variabel, d.h. flexibel bestückt werden kann. Unterschiedliche Anzahlen von Kontaktbahnen einerseits und Kontaktkammern andererseits können insbesondere sinnvoll sein, wenn dieselbe Kontaktbahn zum Kontaktieren mehrerer optoelektronischer Bauelemente in verschiedenen Kontaktkammern verwendet wird, beispielsweise als Masse-Kontakt oder bei paralleler Verschaltung der betreffenden optoelektronischen Bauelemente. Unterschiedliche Anzahlen von Kontaktbahnen einerseits und Kontaktkammern andererseits können insbesondere auch sinnvoll sein, wenn Kontaktbahnen für elektronische Bauelemente erforderlich sind, die keine optoelektronischen Bauelemente sind und deshalb innerhalb derselben Kontaktkammer wie eines der optoelektronischen Bauelemente installiert werden können.

Die Kontaktkammern sind optisch voneinander isoliert, sodass ein in einer jeweiligen Kontaktkammer installiertes optoelektronisches Bauelement zumindest optisch unabhängig von einem in einer benachbarten Kontaktkammer installierten Bauelement betrieben werden kann. Die Kontaktkammern sind durch Trennstege, die parallel zu der Quererstreckung der optoelektronischen Vorrichtung verlaufen, voneinander getrennt.

Die Trennstege können somit auch als Trennwände bezeichnet werden. Die Trennstege können Erhebungen gegenüber einer Erstreckungsebene der elektrisch leitenden Kontaktbahnen bilden. Die Trennstege sind aus einem lichtundurchlässigen Material gebildet oder zumindest abschnittsweise mit einer lichtundurchlässigen Beschichtung überzogen. Die Trennstege sind aus Kunststoff durch Spritzguss gebildet.

Ein optisches Übersprechen zwischen benachbarten Kontaktkammern kann hierdurch effektiv unterbunden werden. Die Kontaktkammern können mit einem Vergussmaterial befüllt sein, insbesondere mit einem Epoxidharz, einem Silikon oder dergleichen. Hierdurch kann der optische Brechungsindex geändert oder angepasst werden; es kann eine spektrale Filterung erfolgen; und/oder das in der jeweiligen Kontaktkammer vorgesehene optoelektronische Bauelement kann vor Umwelteinflüssen geschützt sein. Die verschiedenen Kontaktkammern können in unterschiedlicher Weise mit einem Vergussmaterial befüllt oder nicht befüllt sein.

Gemäß der Erfindung weist die Trägereinrichtung einen umspritzten Leiterrahmen auf. Ein solcher Leiterrahmen ist wird auch als "pre-molded leadframe" bezeichnet. Der umspritzte Leiterrahmen umfasst einen segmentierten (d.h. abschnittsweise unterbrochenen) und zumindest abschnittsweise elektrisch leitfähigen Leiterstreifen aus Metall. Dieser Leiterstreifen kann ein Stanzteil oder ein Stanzbiegeteil sein, das durch einen Stanzprozess (insbesondere vor dem Umspritzen mit Kunststoff) segmentiert, d.h. mit Ausnehmungen versehen worden ist. Hierdurch können aus einem einzigen Leiterstreifen mehrere separate Teile gebildet sein, die insbesondere die genannten Kontaktbahnen und/oder zusätzliche Elemente umfassen, wobei diese separaten Teilen innerhalb einer gemeinsamen Erstreckungsebene oder innerhalb zueinander versetzter Erstreckungsebenen angeordnet sein können. Die voneinander separaten Teilen des Leiterstreifens bzw. hieran installierte elektronische Bauelemente können beispielsweise durch Bonddrähte elektrisch miteinander verbunden sein.

Der Leiterstreifen aus Metall ist teilweise von einem Rahmenabschnitt aus Kunststoff umgeben, wobei der Rahmenabschnitt an einer Oberseite des Leiterstreifens die mehreren Kontaktkammern definiert. Der Rahmenabschnitt umfasst die genannten Trennstege und ist ebenso wie diese aus einem lichtundurchlässigen Material gebildet oder zumindest abschnittsweise mit einer lichtundurchlässigen Schicht überzogen.

Ferner kann der Rahmenabschnitt einen äußeren Rahmen bilden, der die Oberseite des Leiterstreifens abschnittsweise oder vollständig umfänglich umgibt.

Der Leiterstreifen aus Metall kann wenigstens einen elektrischen Anschluss für eine jeweilige Kontaktbahn bilden, um die jeweilige Kontaktbahn bzw. ein hiermit elektrisch verbundenen Bauelement von außerhalb der optoelektronischen Vorrichtung elektrisch kontaktieren zu können. Der elektrische Anschluss kann insbesondere durch einen segmentierten Teil des Leiterstreifens gebildet sein. Vorzugsweise ist für jede Kontaktbahn wenigstens ein elektrischer Anschluss vorgesehen. Insbesondere können mehrere verschieden ausgebildete und/oder voneinander beabstandete elektrische Anschlüsse vorgesehen sein. Durch die Verwendung von Teilen eines Leiterstreifen nicht nur als Kontaktbahnen, sondern auch als elektrische Anschlüsse hat den Vorteil eines besonders einfachen und kompakten Aufbaus, insbesondere im Vergleich zu einer Trägereinrichtung, die auf einer bedruckten Leiterplatte (Printed Circuit Board, PCB) oder einem Keramiksubstrat basiert.

Der jeweilige elektrische Anschluss kann eine elastische Kontaktzunge bilden, um eine zuverlässige Kontaktierung eines mit der Kontaktzunge zusammenwirkenden elektrischen Steckverbinders zu gewährleisten, der von außen mit der optoelektronischen Vorrichtung verbunden wird. Die Kontaktzunge kann gewölbt sein. Die Kontaktzunge ist hierbei vorzugsweise parallel zu der Längserstreckung der Trägereinrichtung ausgerichtet. Die jeweilige Kontaktzunge kann sich insbesondere von einer Schmalseite einer rechteckigen Grundform der Trägereinrichtung weg erstrecken. Eine Anordnung des elektrischen Anschlusses an der Schmalseite ist vorteilhaft, um die Trägereinrichtung und die optoelektronische Vorrichtung im Sinne einer möglichst schlanken äußeren Form kompakt auszubilden.

Das für den Leiterstreifen und insbesondere den elektrischen Anschluss verwendete Metall oder eine Beschichtung hiervon kann eine Nickel-Palladium-Legierung umfassen. Dies besitzt einerseits den Vorteil, dass ein in einer Kontaktkammer zu installierendes optoelektronisches Bauelement gut mit einer Kontaktbahn des Leiterstreifens elektrisch verbunden werden kann (mittels herkömmlicher Bonding-Verfahren). Gleichzeitig besitzt der elektrische Anschluss, insbesondere, wenn dieser als Kontaktzunge ausgebildet ist, durch Verwendung der Nickel-Palladium-Legierung eine optimale Flexibilität, sodass die genannte Kontaktierbarkeit durch einen zugeordneten Steckverbinders besonders gut gewährleistet wird und die Bruchempfindlichkeit des elektrischen Anschlusses minimal ist. Ferner kann ein betreffender elektrischer Anschluss oder eine Kontaktbahn mehrfach kontaktiert/dekontaktiert werden, ohne die Zuverlässigkeit des betreffenden elektrischen Kontakts zu beeinträchtigen.

Es versteht sich, dass der Leiterstreifen mehrere elektrische Anschlüsse bilden kann, wobei die mehreren Anschlüsse gleichartig oder unterschiedlich ausgebildet sein können. Insbesondere können mehrere elastische Kontaktzungen der erläuterten Art vorgesehen sein.

Nach einer Ausführungsform bilden die mehreren elektrischen Anschlüsse des Leiterstreifens zusammen eine Kontaktierungszone für einen elektrischen Steckverbinder, der von außen mit der optoelektronischen Vorrichtung verbunden wird. Die optoelektronische Vorrichtung kann z:B. oberhalb der Kontaktierungszone einen Freiraum aufweisen, durch den eine Buchse zum Einführen und Fixieren des elektrischen Steckverbinders gebildet ist. Die mehreren elektrischen Anschlüsse sind vorzugsweise parallel nebeneinander angeordnet, sodass eine Kontaktierung nach Art eines flexiblen Flachkabels ("Flat Flexibel Cable") möglich ist. Eine separate Buchse ist nicht notwendig. Die Trägereinrichtung kann somit auf besonders einfache und kompakte Weise mit einem externen Microcontroller verbunden werden, um die optoelektronische Vorrichtung betreiben zu können.

Gemäß einer Ausführungsform ist wenigstens einer der mehreren elektrischen Anschlüsse von den mehreren Kontaktbahnen elektrisch isoliert. Dies kann insbesondere dadurch geschehen, dass die elektrischen Anschlüsse und die Kontaktbahnen separate Teile eines segmentierten Leiterstreifens bilden. Der betreffende elektrische Anschluss kann jedoch wahlweise direkt mit einer jeweiligen Kontaktbahn verbunden werden (beispielsweise mittels eines Bonddrahts), was die flexible Bestückbarkeit der Trägereinrichtung z.B. mit optoelektronischen Sendern und/oder Empfängern noch weiter erhöht. Alternativ oder zusätzlich kann eine indirekte elektrische Verbindung vorgesehen sein, insbesondere über ein elektronisches Bauelement, wie beispielsweise eine in einer Kontaktkammer der Trägereinrichtung installierte anwendungsspezifische integrierte Schaltung (Application-Specific Integrated Circuit, ASIC).

Gemäß einer weiteren Ausführungsform ist wenigstens einer der mehreren elektrischen Anschlüsse mit einer der mehreren Kontaktbahnen integral (d.h. einteilig) ausgebildet und hierdurch auch elektrisch verbunden. Insbesondere kann einer der mehreren elektrischen Anschlüsse mit einer Installationskontaktbahn der Trägereinrichtung direkt verbunden und vorzugsweise integral ausgebildet sein.

Bei dieser Installationskontaktbahn kann es sich insbesondere um eine entlang der Quererstreckung zentral angeordnete Kontaktbahn handeln. Die Installationskontaktbahn kann z.B. über den elektrischen Anschluss mit einem vorbestimmten elektrischen Potential, insbesondere mit Masse (Nullpotential) verbunden werden. Vorzugsweise sind alle an der Trägereinrichtung installierten elektronischen Bauelemente (optoelektronische Sender und/oder Empfänger sowie ASICs) auf der Installationskontaktbahn befestigt, wobei zumindest einige der installierten Bauelemente die Installationskontaktbahn auch elektrisch kontaktieren können. Zusätzlich kann jedes installierte Bauelement mittels Bondrähten mit einer oder mehreren der anderen Kontaktbahnen elektrisch verbunden sein.

Nach einer weiteren Ausführungsform ist die Installationskontaktbahn relativ zu den anderen Kontaktbahnen verbreitert, d.h. sie besitzt entlang der genannten Quererstreckung der Trägereinrichtung eine größere Ausdehnung. Somit können auch größere elektronische Einheiten zuverlässig auf der Installationskontaktbahn installiert werden. Sofern alle elektronischen Einheiten auf der Installationskontaktbahn installiert sind, können die anderen Kontaktbahnen vergleichsweise schmal ausgebildet werden, sodass die optoelektronische Vorrichtung insgesamt kompakt ausgebildet sein kann.

Die Kontaktbahnen können jeweils eine im Wesentlichen einheitliche, insbesondere über die Längserstreckung gleichbleibende, Breite besitzen. Abschnittsweise kann die Geometrie jedoch abweichen. Insbesondere kann die Installationskontaktbahn, die vorzugsweise zentral angeordnet ist, einen vergrößerten, insbesondere verbreiterten Bereich aufweisen, an dem z.B. ein ASIC installiert werden kann. Vorzugsweise laufen alle anderen Kontaktbahnen lokal an dem vergrößerten Bereich der Installationskontaktbahn entlang, sodass ein an diesem Bereich installierter ASIC mit lediglich geringem Verdrahtungsaufwand mit jeder der anderen Kontaktbahnen verbunden werden kann. Die durch einen jeweiligen Bonddraht zu überbrückende Distanz ist hierbei vergleichsweise gering, sodass die betreffende Bondverbindung zuverlässig einfach hergestellt werden kann und vergleichsweise haltbar ist, und sodass auch elektromagnetische Störeinflüsse nicht leicht eingekoppelt werden.

Es versteht sich, dass zusätzlich zu den genannten elektronischen Bauelementen auch andere elektronische Bauelemente auf der Trägereinrichtung installiert werden können. So kann beispielsweise ein Temperatursensor vorgesehen werden, um beispielsweise eine übermäßige Erwärmung der optoelektronischen Vorrichtung detektieren zu können. Der Temperatursensor kann insbesondere in einen ASIC auf der Trägereinrichtung integriert sein.

An einer Unterseite der Trägereinrichtung kann wenigstens ein Kontaktierungsbereich vorgesehen sein, in dem eine jeweilige der mehreren Kontaktbahnen für eine elektrische Kontaktierung freiliegt. Hierdurch kann unabhängig von dem genannten elektrischen Steckverbinder, der für eine elektrische Kontaktierung in einem Normalbetrieb der optoelektronischen Vorrichtung vorgesehen ist, eine einfache elektrische Kontaktierung der jeweiligen Kontaktbahn im Rahmen eines Herstellungsprozesses der Trägereinrichtung oder der optoelektronischen Vorrichtung erfolgen. Dies kann beispielsweise erwünscht sein, ob die Trägereinrichtung oder die optoelektronische Vorrichtung zu testen, zu kalibrieren oder abschließend zu programmieren. Insbesondere kann einer der unterseitigen Kontaktierungsbereiche ein sogenanntes Fuse Pad bilden, um durch Anlegen einer vorbestimmten erhöhten Spannung elektrische Verbindungen innerhalb der optoelektronischen Vorrichtung und insbesondere eines hieran installierten ASIC gezielt zu zerstören.

Ferner kann der Leiterstreifen wenigstens einen seitlichen Kontaktierungsbereich aufweisen, in dem eine jeweilige der mehreren Kontaktbahnen für eine elektrische Kontaktierung freiliegt. Insbesondere kann eine Kontaktbahn an zwei voneinander beabstandeten seitlichen Abschnitten der Trägereinrichtung aus dem Rahmenabschnitt herausgeführt sein. Beispielsweise kann ein jeweiliger Endabschnitt einer Kontaktbahn durch einen seitlichen Kontaktierungsbereich gebildet sein. Somit kann z.B. die Leitfähigkeit der Kontaktbahn im Rahmen eines maschinellen Testzyklus auf einfache Weise überprüft werden.

Gemäß einer bevorzugten Ausführungsform weist die optoelektronische Vorrichtung ein Linsenelement und eine Halteeinrichtung auf, wobei das Linsenelement oberhalb der Trägereinrichtung vorgesehen ist und wenigstens einen Linsenabschnitt für den wenigstens einen optoelektronischen Sender und/oder den wenigstens einen optoelektronischen Empfänger aufweist, und wobei die Halteeinrichtung die Trägereinrichtung und das Linsenelement relativ zueinander hält. Im Zusammenhang mit der Erfindung ist unter einem Linsenelement ein Abbildungselement zu verstehen, das insbesondere refraktive (d.h. lichtbrechende) Eigenschaften aufweisen kann. Der jeweilige Linsenabschnitt kann strahlformende Eigenschaften aufweisen, insbesondere indem der jeweilige Linsenabschnitt an einer Seite oder an zwei Seiten eine Wölbung aufweist (z.B. als Sammellinse, Zerstreungslinse oder Fresnel-Linse). Alternativ oder zusätzlich hierzu kann der jeweilige Linsenabschnitt eine Umlenkung eines Strahlbündels bewirken, d.h. eine Änderung der Ausbreitungsrichtung eines emittierten oder empfangenen Strahlbündels. Insbesondere kann der jeweilige Linsenabschnitt eine Keilform aufweisen (z.B. Ausgestaltung als Keillinse mit zwei in einem spitzen Winkel zueinander ausgerichteten Planflächen). Der jeweilige Linsenabschnitt kann parallel oder schräg zu einer Erstreckungsebene der Trägereinrichtung ausgerichtet sein. Das Linsenelement kann außerhalb des jeweiligen Linsenabschnitts plattenförmig sein. Der jeweilige Linsenabschnitt kann integral ausgebildet und/oder oberhalb des optoelektronischen Senders bzw. Empfängers angeordnet sein.

Die optoelektronische Vorrichtung zeichnet sich durch einen modularen Aufbau aus, bei dem die Vorrichtung nach Art eines Baukastensystems aus verschiedenen separaten Komponenten zusammengesetzt ist. Diese separaten Komponenten umfassen zumindest die Trägereinrichtung, das Linsenelement und die Halteeinrichtung. Die einzelnen Komponenten werden vorzugsweise lösbar miteinander verbunden oder aneinandergehalten. Insbesondere können die Komponenten kraftschlüssig und/oder formschlüssig aneinander gehalten sein. Die Komponenten können entlang der genannten Vertikalrichtung im Wesentlichen hintereinander angeordnet sein (z.B. in einer Sandwich-Struktur). Hierdurch können verschiedene Varianten der Trägereinrichtung und des Linsenelements sowie optionale Komponenten auf einfache Weise auf Basis einer universellen Modulplattform miteinander kombiniert werden, um unterschiedliche optoelektronische Vorrichtungen herzustellen, wobei einige Komponenten der unterschiedlichen optoelektronischen Vorrichtungen gleichartig sein können (z.B. die Halteeinrichtung).

Die Halteeinrichtung dient dazu, zumindest die Trägereinrichtung und das Linsenelement relativ zueinander zu halten, wobei eine Ausrichtung des Linsenelements bezüglich der Trägereinrichtung eingehalten wird, die mit dem wenigstens einen optoelektronischen Sender und/oder Empfänger bestückt ist. Hierbei kann die Halteeinrichtung das Linsenelement direkt oder indirekt an der Trägereinrichtung sichern und/oder fixieren. Die Halteeinrichtung kann hierfür beispielsweise eine Klammer oder wenigstens ein klammerartiges Element aufweisen, welches zumindest die Trägereinrichtung und das Linsenelement umgreift oder hintergreift. Zusätzlich oder alternativ kann die Halteeinrichtung gehäuseartig oder käfigartig ausgebildet sein, wobei eine solche Halteeinrichtung die Trägereinrichtung und das Linsenelement nicht vollständig umschließen muss, insbesondere nicht vollflächig und auch nicht an jeder Seite der Vorrichtung. Die Halteeinrichtung kann somit zumindest funktional als Gehäuse der Vorrichtung dienen oder sogar ein echtes, zumindest überwiegend geschlossenes Gehäuse sein, wobei zumindest eine mechanische Kapselung der Komponenten der Vorrichtung sichergestellt wird.

Die Halteeinrichtung kann insbesondere eine Basisplatte mit mehreren Seitenwänden und/oder mit mehreren, insbesondere zwei, vier oder sechs paarweise einander gegenüberliegenden, Haltearmen oder Halteabschnitten aufweisen. Die Basisplatte kann eine einheitliche Plattengröße besitzen, die z.B. an die Form und Größe der Trägereinrichtung und/oder des Linsenelements angepasst ist. Hierdurch kann die Vorrichtung robust und kompakt ausgebildet werden, wobei ein Anhaften oder Eindringen von Schmutz und dergleichen an bzw. in die Vorrichtung vermieden wird. Vorzugsweise ist die Basisplatte an einer Unterseite der Trägereinrichtung angeordnet und bildet einen Bodenabschnitt. Die Halteeinrichtung kann einen zumindest abschnittsweise stufenförmigen und/oder U-förmigen Querschnitt und/oder mehrere Öffnungen aufweisen, sodass eine in die Halteeinrichtung eingelegte Komponente der Vorrichtung, welche zumindest abschnittsweise komplementär zu der Halteeinrichtung ausgebildet ist, in der Halteeinrichtung seitlich und/oder in Vertikalrichtung gefangen ist, ohne dass es hierfür gesonderter Befestigungsmittel bedarf.

Ferner kann die optoelektronische Vorrichtung wenigstens ein Aperturelement aufweisen, das oberhalb der Trägereinrichtung vorgesehen ist und wenigstens einen Aperturabschnitt für den wenigstens einen optoelektronischen Sender und/oder den wenigstens einen optoelektronischen Empfänger aufweist. Das Aperturelement kann insbesondere eine geometrische Begrenzung eines von dem optoelektronischen Empfänger detektierten Strahlenbündels bewirken.

Die Halteeinrichtung kann insbesondere zweiteilig ausgebildet sein, wobei die Halteeinrichtung ein Unterteil sowie ein Oberteil umfasst. Hierbei können z.B. die Trägereinrichtung und das Linsenelement zwischen dem Unterteil und dem Oberteil der Halteeinrichtung gefangen sein. Das Unterteil und das Oberteil der Halteeinrichtung sind insbesondere mittels eines Rastschlusses aneinander befestigt.

Das Oberteil der Halteeinrichtung kann wenigstens einen Aperturabschnitt für den wenigstens einen optoelektronischen Sender und/oder den wenigstens einen optoelektronischen Empfänger bilden.

Alternativ zu einer zweiteilig ausgebildeten Halteeinrichtung kann diese auch einteilig ausgebildet sein und eine offene Oberseite aufweisen, wobei das Linsenelement oder das Aperturelement an der Oberseite der Halteeinrichtung angeordnet sind.

Die Erfindung bezieht sich ferner auf ein System mit mehreren optoelektronischen Vorrichtungen nach einer der vorstehend beschriebenen Ausführungsformen, wobei die Kontaktkammern zumindest einiger der mehreren optoelektronischen Vorrichtungen in unterschiedlichen Konfigurationen mit jeweils wenigstens einem optoelektronischen Sender und/oder wenigstens einem optoelektronischen Empfänger bestückt sind. Hierdurch kann das genannte Baukastensystem verwirklicht werden.

Jede der mehreren optoelektronischen Vorrichtungen kann ein jeweiliges Linsenelement aufweisen, das oberhalb der Trägereinrichtung vorgesehen ist und wenigstens einen Linsenabschnitt für den wenigstens einen optoelektronischen Sender und/oder den wenigstens einen optoelektronischen Empfänger aufweist, wobei die Linsenelemente von wenigstens einigen der mehreren optoelektronischen Vorrichtungen sich hinsichtlich ihrer jeweiligen Formgebung von den Linsenelementen von anderen der mehreren optoelektronischen Vorrichtungen unterscheiden.

Die mehreren optoelektronischen Vorrichtungen können ferner jeweils eine Halteeinrichtung aufweisen, die die Trägereinrichtung und das Linsenelement der jeweiligen optoelektronischen Vorrichtung relativ zueinander hält.

Das System kann so ausgestaltet sein, dass jede der mehreren optoelektronischen Vorrichtungen wenigstens ein Aperturelement aufweist, das oberhalb der Trägereinrichtung vorgesehen ist und wenigstens einen Aperturabschnitt für den wenigstens einen optoelektronischen Sender und/oder den wenigstens einen optoelektronischen Empfänger aufweist, wobei die Aperturelemente von wenigstens einigen der mehreren optoelektronischen Vorrichtungen sich hinsichtlich ihrer jeweiligen Anordnung und/oder Formgebung von den Aperturelementen von anderen der mehreren optoelektronischen Vorrichtungen unterscheiden.

Die Erfindung wird nachfolgend rein beispielhaft anhand der Zeichnungen beschrieben, in denen:
- Fig. 1: eine Explosionsdarstellung einer Ausführungsform einer optoelektronischen Vorrichtung ist;
- Fig. 2: eine Perspektivansicht von Komponenten der Vorrichtung von Fig. 1 ist;
- Fig. 3: eine Perspektivansicht der Vorrichtung von Fig. 1 in einem zusammengesetzten Zustand ist;
- Fig. 4: eine Draufsicht von oben auf ein Linsenelement der Vorrichtung von Fig. 1 ist;
- Fig. 5: zwei Perspektivansichten eines Montageorts für eine Vorrichtung gemäß Fig. 1, (a) ohne montierte Vorrichtung und (b) mit montierter Vorrichtung, umfasst;
- Fig. 6: zwei Perspektivansichten eines weiteren Montageorts für eine Vorrichtung gemäß Fig. 1, (a) ohne montierte Vorrichtung und (b) mit montierter Vorrichtung, umfasst;
- Fig. 7: eine Perspektivansicht von schräg oben auf eine Trägereinrichtung gemäß der Erfindung für die Vorrichtung von Fig. 1 ist.
- Fig. 8: eine Draufsicht von oben auf eine Trägereinrichtung 2. gemäß der Erfindung für die Vorrichtung von Fig. 1 ist.
- Fig. 9: eine Draufsicht von unten auf die Trägereinrichtung von Fig. 1, Fig. 7 und Fig. 8 ist.

In den Zeichnungen sind gleiche oder gleichartige Elemente mit den gleichen Bezugszeichen gekennzeichnet.

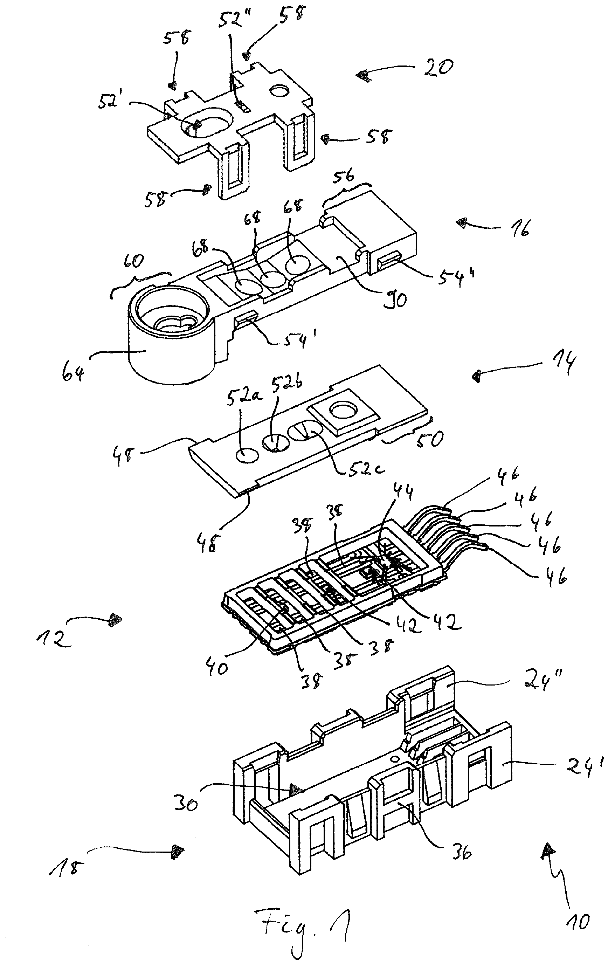

Eine optoelektronische Vorrichtung 10 umfasst eine im Wesentlichen plattenförmige Trägereinrichtung 12, ein erstes Aperturelement 14, ein Linsenelement 16 sowie eine ein Unterteil 18 sowie ein Oberteil 20 umfassende Halteeinrichtung. Das Oberteil 20 der Halteeinrichtung bildet bei dem hier gezeigten Ausführungsbeispiel gleichzeitig ein zweites Aperturelement der optoelektronischen Vorrichtung 10. Sämtliche dieser Komponenten sind in Fig. 1 von schräg oben gezeigt, d.h. die Perspektive ist schräg auf eine jeweilige Oberseite der Komponenten gerichtet.

Nachfolgend wird beschrieben, wie die Vorrichtung 10 zusammengesetzt wird, wobei die einzelnen Komponenten der optoelektronischen Vorrichtung 10 genauer erläutert werden.

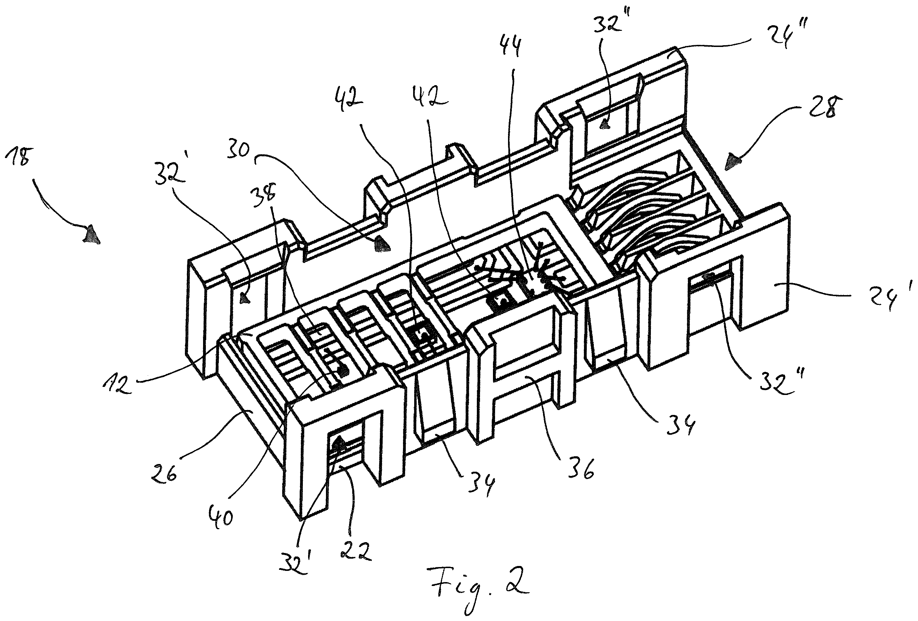

Zunächst wird die Trägereinrichtung 12 in das Unterteil 18 eingelegt. Das Unterteil 18 mit eingelegter Trägereinrichtung 12 ist in Fig. 2 dargestellt, wobei der Maßstab in Fig. 2 gegenüber Fig. 1 vergrößert ist. Das Unterteil 18 weist einen Bodenabschnitt 22 mit mehreren hiervon nach oben abkragenden Verbindungsabschnitten auf. Im Einzelnen erstrecken sich zwei bezüglich der Längserstreckung des Unterteils 18 spiegelsymmetrisch ausgebildete Seitenteile 24', 24" nach oben weg von dem Bodenabschnitt 22, wobei die Seitenteile 24', 24" im Wesentlichen senkrecht zu dem Bodenabschnitt 22 ausgerichtet sind. Ferner weist der Bodenabschnitt 22 einen stirnseitigen Riegel 26 sowie einen Kammabschnitt 28 auf. Das auf diese Weise U-förmig ausgebildete Unterteil 18 weist einen nach oben vollständig und seitlich teilweise geöffneten Aufnahmeraum 30 zur Aufnahme der Trägereinrichtung 12, des ersten Aperturelements 14 und des Linsenelements 16 auf. Die Größe und Form des Aufnahmeraums 30 entsprechen abschnittsweise im Wesentlichen der Größe und Form der Trägereinrichtung 12, des Aperturelements 14 und des Linsenelements 16. Die Komponenten 12, 14 und 16 können somit passgenau in das Unterteil 18 eingesetzt werden.

Die Seitenteile 24', 24" weisen jeweils zwei rechteckförmige Öffnungen 32' und 32" sowie zwei voneinander beabstandete, außenseitige Rastnasen 34 auf. Ferner weisen die Seitenteile 24', 24" jeweils einen zentral angeordneten, außenseitigen Rastriegel 36 auf. Der Aufnahmeraum 30 ist im Bereich des Kammabschnitts 28 gegenüber dem mittigen Bereich verbreitert.

Die Trägereinrichtung 12 ist gemäß der Erfindung als Leiterrahmen ausgebildet, der einen mit Kunststoff umspritzten segmentierten Leiterstreifen 93 aus Metall aufweist (sogenannter "pre-molded leadframe") und der variabel bestückbar ist. Der Umfang der Trägereinrichtung 12 ist komplementär zu dem Aufnahmeraum 30 des Unterteils 18 ausgebildet, so dass die Trägereinrichtung 12 wie in Fig. 2 dargestellt in das Unterteil 18 eingelegt werden kann, wobei die Trägereinrichtung 12 in der Ebene des Bodenabschnitts 22 zwischen dem Riegel 26, dem Kammabschnitt 28 sowie den Seitenteilen 24', 24" seitlich gefangen ist. Die Oberseite der Trägereinrichtung 12 ist in Längsrichtung in mehrere Kontaktkammern 38 eingeteilt, wobei grundsätzlich in jeder Kontaktkammer 38 ein optoelektronischer Sender oder ein optoelektronischer Empfänger angebracht und elektrisch kontaktiert werden kann. Die in Fig. 1 dargestellte erfindungsgemäße

Trägereinrichtung 12 weist einen optoelektronischen Sender 40, zwei optoelektronische Empfänger 42 sowie einen ASIC 44 (Application-Specific-Integrated-Circuit) auf. Zur Anbindung der Trägereinrichtung 12 an einen externen Microcontroller (nicht gezeigt) sind mehrere elektrische Anschlüsse 46 vorgesehen, welche sich an einer Schmalseite der Trägereinrichtung 12 in einer einheitlichen Bogenform als eine jeweilige Kontaktzunge von der Trägereinrichtung 12 wegerstrecken. Wenn die Trägereinrichtung 12 in das Unterteil 18 eingelegt ist, greifen die Anschlüsse 46 rückfedernd in den Kammabschnitt 28 des Unterteils 18 ein, wodurch eine flexible Kontaktierungszone zum Kontaktieren eines oberhalb der Kontaktierungszone in einen Freiraum der Vorrichtung 10 eingeführten elektrischen Steckverbinders, insbesondere eines flexiblen Flachkabels, (nicht gezeigt), gebildet ist (Fig. 2).

Nachdem die Trägereinrichtung 12 in das Unterteil 18 eingelegt wurde, wird das erste Aperturelement 14 in den Aufnahmeraum 30 des Unterteils 18 eingelegt (nicht gezeigt). Hierbei greift ein jeweiliger seitlicher Vorsprung 48 des ersten Aperturelements 14 in eine jeweilige Öffnung 32', 32" der Seitenteile 24', 24" ein (Fig. 1 und Fig. 2). Ferner greift ein verbreiterter Bereich 50 des ersten Aperturelements 14 in den im Bereich des Kammabschnitts 28 verbreiterten Aufnahmeraum 30 ein. Auf diese Weise ist das erste Aperturelement 14 insbesondere in Längsrichtung der Vorrichtung 10 nicht verschiebbar und diesbezüglich an dem Unterteil 18 gesichert. Das erste Aperturelement 14 in Fig. 1 weist ferner drei unterschiedlich ausgebildete Aperturabschnitte 52a, 52b und 52c auf, welche in Längsrichtung hintereinander an dem ersten Aperturelement 14 angeordnet sind und durch im Wesentlichen kegelstumpfförmig umrandete Öffnungen gebildet sind.

Als nächstes wird das Linsenelement 16 in den Aufnahmeraum 30 des Unterteils 18 eingelegt, wobei jeweils ein seitlicher Vorsprung 54', 54" in eine jeweilige Öffnung 32', 32" der Seitenteile 24', 24" eingreift. Ferner greift ein verbreiterter Bereich 56 des Linsenelements 16 in den im Bereich des Kammabschnitts 28 verbreiterten Bereich des Aufnahmeraums 30 ein. Das Linsenelement 16 ist auf diese Weise in Längs- und Querrichtung in einer Ebene parallel zu dem Bodenabschnitt 22 an dem Unterteil 18 fixiert.

Abschließend wird das Oberteil 20 der Halteeinrichtung mittels Rastschluss an dem Unterteil 18 befestigt, wobei das Oberteil 20 hierfür vier nach unten abkragende Rastlaschen 58 aufweist, welche jeweils mit einer der Rastnasen 34 der Seitenteile 24', 24" verrasten. Die Trägereinrichtung 12, das Aperturelement 14 und das Linsenelement 16 sind nun zwischen dem Oberteil 20 und dem Unterteil 18 vollständig gefangen und aneinander fixiert. Das Unterteil 18 der Halteeinrichtung, die Trägereinrichtung 12, das Aperturelement 14, das Linsenelement 16 und das Oberteil 20 der Halteeinrichtung sind somit entlang einer Vertikalrichtung hintereinander angeordnet.

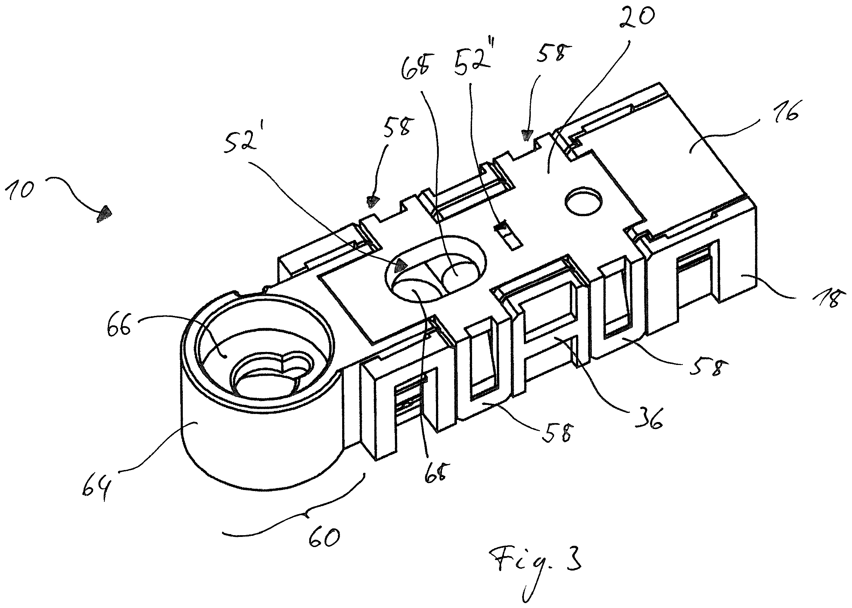

Die derart zusammengesetzte Vorrichtung 10 ist in Fig. 3 perspektivisch dargestellt. Das Oberteil 20 (zweites Aperturelement) weist zwei Aperturabschnitte 52', 52" auf (vgl. Fig. 1 und Fig. 3). Ferner ist erkennbar, dass das Oberteil 20 in einen komplementären Eingriffsabschnitt 90 des Linsenelements 16 (vgl. Fig. 1) eingreift, sodass das Oberteil 20 bündig mit dem Linsenelement 16 abschließt und eine im Wesentlichen glatte Oberseite der Vorrichtung 10 gebildet ist. Darüber hinaus wird das Linsenelement 16 zusätzlich fixiert und die Größe der Vorrichtung 10 klein gehalten.

Durch die drei Aperturabschnitte 52a, 52b und 52c des ersten Aperturelements 14 in Kombination mit den zwei Aperturabschnitten 52', 52" des zweiten Aperturelements bzw. Oberteils 20 werden die optischen Eigenschaften der optoelektronischen Vorrichtung 10 festgelegt und unerwünschte Störeinflüsse unterdrückt, indem eine geometrische Begrenzung des jeweiligen Querschnitts der emittierten oder empfangenen Strahlenbündel erfolgt.

Die Vorrichtung 10 besitzt einen schlanken, im Wesentlichen quaderförmigen Grundkörper, wobei die Außenhaut der Vorrichtung sich durch im Wesentlichen bündig miteinander abschließende Flächen auszeichnet. Insbesondere schließen die Rastlaschen 58 bündig mit der Außenseite der Seitenteile 24', 24" ab.

Das im Wesentlichen plattenförmige Linsenelement 16 weist einen integral ausgebildeten, mechanischen Kodierabschnitt 60 auf, welcher sich in Längsrichtung von dem ansonsten plattenförmig ausgebildeten Linsenelement 16 weg erstreckt (Fig. 1). Der ringförmig ausgebildete Kodierabschnitt 60 weist einen Hohlzylinder 64 auf, welcher senkrecht von einer Erstreckungsebene von drei in Längsrichtung hintereinander angeordneten Linsenabschnitten 68 des Linsenelements 16 abkragt. Die Linsenabschnitte 68 des Linsenelements 16 weisen strahlformende Eigenschaften auf und können beispielsweise Konvex-Linsen, Bikonvex-Linsen oder Fresnel-Linsen umfassen.

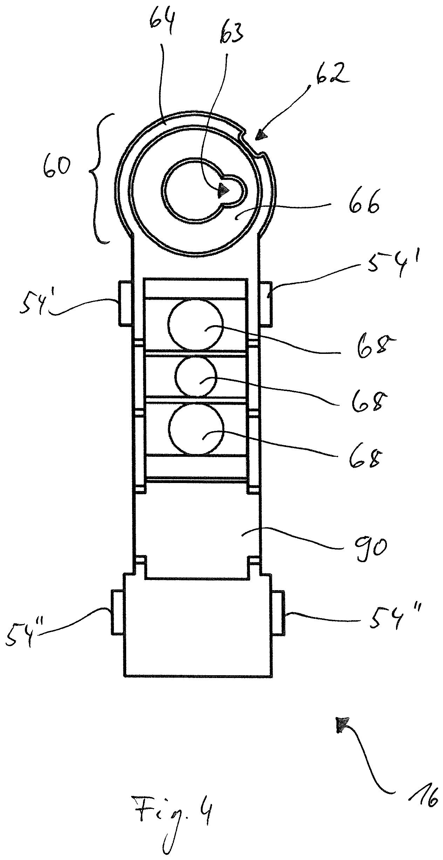

Weitere Details zu dem Linsenelement 16 sind in Fig. 4 gezeigt, in der das Linsenelement 16 in einer Draufsicht auf die Oberseite des Linsenelements 16 dargestellt ist. Das in Fig. 4 gezeigte Linsenelement 16 weist an dem Kodierabschnitt 60 ein erstes Kodierelement 62 und ein zweites Kodierelement 63 auf. Das erste Kodierelement 62 ist als rechteckförmige Vertiefung an dem Außenumfang des Hohlzylinders 64 des Kodierabschnitts 60 ausgebildet, wobei sich das erste Kodierelement 62 parallel zu der Zylinderachse (in Fig. 4 senkrecht zur Papierebene) erstreckt, sodass sich eine rechteckförmige Nut in dem Zylindermantel des Hohlzylinders 64 ergibt. Innerhalb des Hohlzylinders 64 erstreckt sich senkrecht zu dessen Längsachse eine Ringscheibe 66. An dem Innenumfang der Ringscheibe 66 ist das zweite Kodierelement 63 vorgesehen, welches als im Wesentlichen halbkreisförmige Vertiefung ausgebildet ist und sich parallel zu der Zylinderachse als Rundnut erstreckt.

Das erste Kodierelement 62 ist lediglich beispielhaft dafür vorgesehen, die zugrundeliegende Vorrichtung 10 bezüglich eines Vorrichtungstyps zu identifizieren. Ein Vorrichtungstyp ist insbesondere durch die jeweilige Ausbildung des Linsenelements 16, des Oberteils und/oder des ersten Aperturelements sowie durch die Bestückung der Trägereinrichtung 12 mit optoelektronischen Sendern 40 bzw. Empfängern 42 charakterisiert. Hierbei können sich insbesondere die Position und die Ausbildung von Linsenabschnitten 68 der Linsenelemente 16 unterscheiden. Das zweite Kodierelement 63 ist dafür vorgesehen, die Vorrichtung 10 bezüglich eines Bus zu identifizieren, der zur Anbindung der Trägereinrichtung 12 an einen Microcontroller vorgesehen ist.

Diese Aufzählung ist lediglich beispielhaft. Grundsätzlich können die Kodierelemente 62, 63 die optoelektronische Vorrichtung 10 bezüglich frei definierbarer Merkmale identifizieren. Die Kodierelemente 62, 63 sind neben ihrer Form lediglich in Abhängigkeit ihrer Winkelstellung um die Längsachse des Hohlzylinders 64 definiert, wobei die Winkelstellung des jeweiligen Kodierelements 62, 63 eine eindeutige Identifizierung der Vorrichtung 10 bezüglich des dem jeweiligen Kodierelement 62, 63 zugeordneten Merkmals ermöglicht.

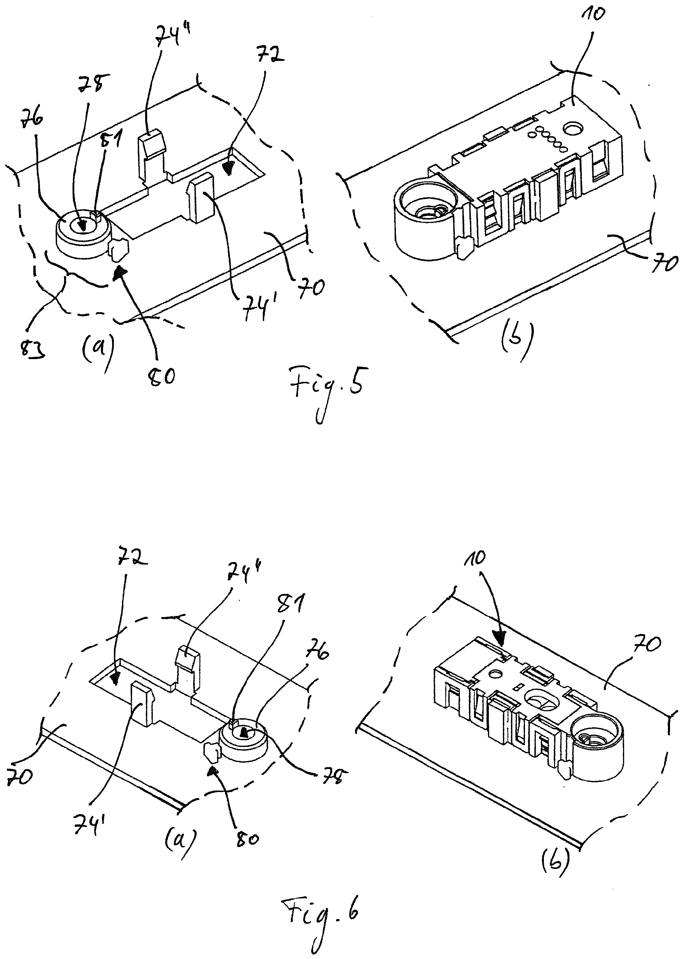

In Fig. 5 sind zwei Perspektivansichten eines Montageorts für eine optoelektronische Vorrichtung 10 gezeigt, der im Zusammenhang mit der Erfindung auch als Montageumgebung der optoelektronischen Vorrichtung 10 bezeichnet wird. In Fig. 5 (a) ist der Montageort als solcher gezeigt, d.h. ohne dass eine betreffende Vorrichtung 10 montiert ist. Der Montageort ist gekennzeichnet durch einen Abschnitt einer Grundplatte 70 mit einer rechteckförmigen Öffnung 72, an deren inneren Längskanten zwei einander gegenüberliegende Rastarme 74', 74" vorgesehen sind. Benachbart zu einer Schmalseite der Öffnung 72 ist ein Zylinder 76 ausgebildet, der sich senkrecht zu der Ebene der Grundplatte 70 erstreckt und mit einer zentralen Öffnung 78 versehen ist. Die Öffnung 78 kann ein Innengewinde für eine nicht gezeigte Schraube aufweisen.

Der Zylinder 76 weist ein erstes Dekodierelement 80 und ein zweites Dekodierelement 81 auf. Das erste Dekodierelement 80 ist T-förmig ausgebildet und von der Mantelfläche des Zylinders 76 in radialer Richtung beabstandet. Die Höhe des Dekodierelements 80 ist geringer als die Höhe des Zylinders 76. Das zweite Dekodierelement 81 ist an der Stirnseite des Zylinders 76 ausgebildet und weist abschnittsweise eine zylindrische Form auf. Der Zylinder 76 sowie die Dekodierelemente 80 und 81 bilden zusammen einen Dekodierabschnitt 83 für den Kodierabschnitt 60 einer Vorrichtung 10. Der Dekodierabschnitt 83 ist einteilig mit der Grundplatte 70 ausgebildet. Die Kanten des Zylinders 76 sowie der Dekodierelemente 80 und 81 weisen eine jeweilige Fase auf, welche die Montage der Vorrichtung 10 erleichtert.

Die an dem in Fig. 5 (a) gezeigten Montageort zu montierende Vorrichtung 10 wird mit der Oberseite der Vorrichtung 10 voraus montiert, so dass die Vorrichtung 10 die in Fig. 5 (b) dargestellte Position einnimmt, in der die Oberseite der Vorrichtung 10 der Öffnung 72 der Grundplatte 70 zugewandt ist. Durch den Dekodierabschnitt 83 ist sichergestellt, dass nur diejenige Vorrichtung 10 montiert werden kann, die einen komplementär zu dem Dekodierabschnitt 83 ausgebildeten Kodierabschnitt 60 aufweist, welcher die Montage der Vorrichtung 10 an dem betreffenden Montageort durch Formschluss eindeutig festlegt. Im montierten Zustand greift das erste Kodierelement 62 in das erste Dekodierelement 80 ein. Ferner greift das zweite Kodierelement 63 abschnittsweise in das zweite Dekodierelement 81 ein. Darüber hinaus sind die Rastarme 74', 74" mit den Rastriegeln 36 des Unterteils 18 verrastet, so dass die Vorrichtung 10 sicher an der Grundplatte 70 befestigt ist.

In Fig. 6 ist ein weiterer Montageort für eine Vorrichtung 10 gezeigt, wobei die Vorrichtung 10 im Gegensatz zu dem Fall von Fig. 5 (b) in Fig. 6 (b) umgekehrt montiert ist, d.h. die strahlungsemittierende bzw. strahlungsempfangende Oberseite der Vorrichtung 10 ist der Grundplatte 70 abgewandt. Die Vorrichtung 10 kann somit flexibel auf unterschiedliche Weise an einem im Wesentlichen gleich ausgebildeten Montageort montiert werden, wobei hierfür lediglich die Positionen der Kodierelemente 62, 63 und die Positionen der Dekodierelemente 80, 81 aufeinander abgestimmt sein müssen (vgl. Fig. 5 (a) und Fig. 6 (a)).

Vorzugsweise ist die Grundform des Kodierabschnitts 60 (insbesondere der Hohlzylinder 64 mit Ringscheibe 66) bezüglich einer Mittenebene der optoelektronischen Vorrichtung 10, die senkrecht zu der Vertikalrichtung steht, symmetrisch ausgebildet. Ferner ist es bevorzugt, wenn eine Befestigungseinrichtung zum Befestigen der optoelektronischen Vorrichtung 10 an einer Montageumgebung (insbesondere die Rastriegel 36 der Halteeinrichtung für die Rastarme 74', 74" der Grundplatte 70) bezüglich einer Mittenebene der optoelektronischen Vorrichtung 10, die senkrecht zu der Vertikalrichtung steht, symmetrisch ausgebildet ist. Hierdurch kann die Vorrichtung 10 besonders einfach wahlweise in einer von zwei verschiedenen Ausrichtungen ihrer Oberseite an der Montageumgebung befestigt werden, wie anhand der Fig. 5 und 6 erläutert wurde.

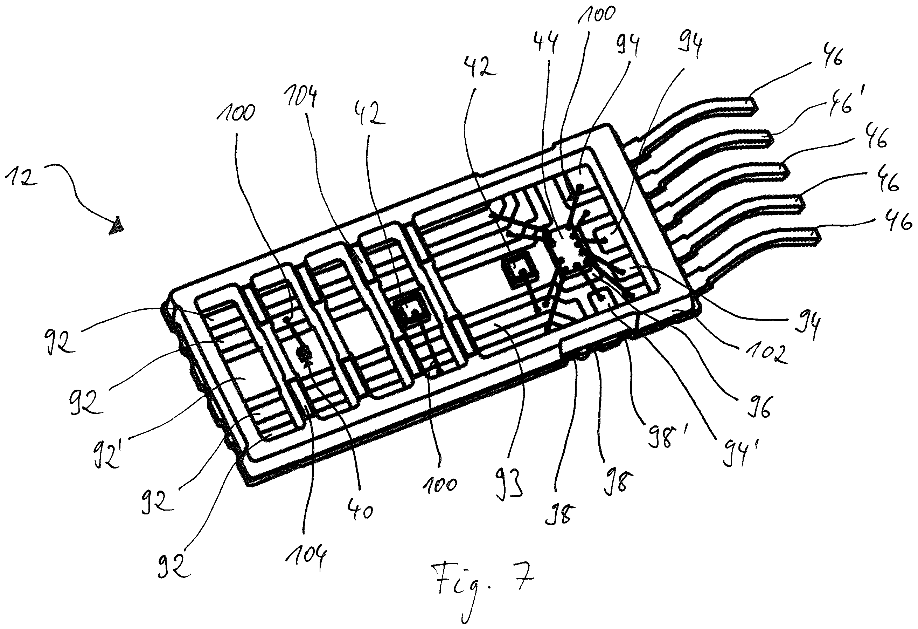

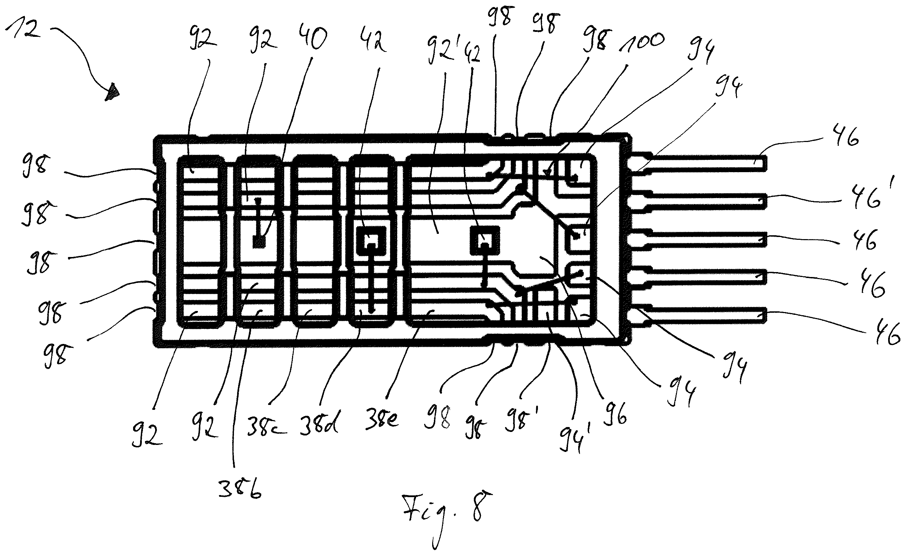

Weitere Details zu der erfindungsgemäßen Trägereinrichtung 12 werden im Folgenden mit Bezug auf Fig. 7 bis 9 erläutert. Die in Fig. 7 gezeigte Trägereinrichtung 12 entspricht derjenigen von Fig. 1. Die in Fig. 8 in einer Oberansicht gezeigte Trägereinrichtung 12 unterscheidet sich von der in Fig. 7 gezeigten Trägereinrichtung 12 im Wesentlichen dadurch, dass die Trägereinrichtung 12 von Fig. 8 keinen ASIC 44 aufweist.

Die Trägereinrichtung 12 weist grundsätzlich mehrere elektrisch leitende Kontaktbahnen 92 auf, welche an einem segmentierten Leiterstreifen 93 ausgebildet sind. In den gezeigten Ausführungsvarianten der Trägereinrichtung 12 sind beispielhaft jeweils fünf Kontaktbahnen 92 vorgesehen, welche sich in Längsrichtung an der Oberseite der Trägereinrichtung 12 durch sämtliche der fünf Kontaktkammern 38 erstrecken und im Wesentlichen parallel zueinander sind. Somit ist jede Kontaktbahn 92 in jeder Kontaktkammer 38 elektrisch kontaktierbar. Es versteht sich, dass sich hierfür nicht jede Kontaktbahn 92 vollständig durch eine jeweilige Kontaktkammer 38 hindurch erstrecken muss. So kann eine betreffende Kontaktbahn 92 auch lediglich abschnittsweise durch eine Kontaktkammer 38 verlaufen bzw. lediglich abschnittsweise freiliegen, wobei z.B. ein optoelektronischer Empfänger 42 dennoch in der betreffenden Kontaktkammer 38 installiert werden kann.

Zur Installation von (opto-) elektronischen Bauelementen 40, 42, 44 ist eine zentral angeordnete Kontaktbahn 92' vorgesehen, auf der die Bauelemente 40, 42, 44 in einer variablen Bestückung befestigt werden und die im Zusammenhang mit der Erfindung auch als Installationskontaktbahn bezeichnet wird. Zusätzlich können die Bauelemente 40, 42, 44 (beispielsweise durch direkten Kontakt an ihrer Unterseite) elektrisch mit der zentralen Kontaktbahn 92' verbunden sein, wobei die zentrale Kontaktbahn 92' ein vorbestimmtes elektrisches Potential tragen kann. Jedes der Bauelemente 40, 42, 44 wird vorzugsweise mit wenigstens einer weiteren Kontaktbahn 92 elektrisch verbunden (mittels eines jeweiligen Bonddrahts 100). Nachdem ein Bauelement 40, 42, 44 in einer jeweiligen Kontaktkammer 38 installiert worden ist, kann die betreffende Kontaktkammer 38 individuell mit einem Vergussmaterial, insbesondere mit einem Epoxidharz, einem Silikon oder dergleichen, befüllt werden (nicht gezeigt). Die Haltbarkeit der Trägereinrichtung sowie die Zuverlässigkeit der optoelektronischen Vorrichtung kann hierdurch verbessert werden, und es können optische Eigenschaften angepasst werden (Brechungsindex, spektrale Filterung).

Die zentrale Kontaktbahn 92' ist relativ zu den anderen benachbarten Kontaktbahnen 92 breiter ausgebildet, sodass verschieden große Bauelemente 40, 42, 44 gemeinsam auf der zentralen Kontaktbahn 92' installiert werden können. Ferner weist die zentrale Kontaktbahn 92' einen lokal verbreiterten Bereich 96 auf, sodass der ASIC 44 bequem an dem Bereich 96 installiert werden kann (Fig. 7). Die übrigen (nicht-zentralen) Kontaktbahnen 92 sind abschnittsweise direkt oder über eine andere Kontaktbahn 92 indirekt benachbart an dem Bereich 96 entlang geführt und über einen jeweiligen seitlichen elektrischen Anschluss 98 kontaktierbar. Darüber hinaus sind sämtliche Kontaktbahnen 92, 92' über einen jeweiligen stirnseitigen elektrischen Anschluss 98 kontaktierbar, wobei die stirnseitigen elektrischen Anschlüsse 98 den elektrischen Anschlüssen 46, 46' (Kontaktzungen) in Längsrichtung gegenüberliegen.

Die zentrale Kontaktbahn 92' ist integral mit dem elektrischen Anschluss 46' ausgebildet. Die anderen elektrischen Anschlüsse 46 sind hingegen von den Kontaktbahnen 92 getrennt und lediglich über ein jeweiliges Kontaktfeld 94 auf der Oberseite der Trägereinrichtung 12 kontaktierbar, wobei die Kontaktfelder 94 von den Kontaktbahnen 92 elektrisch isoliert sind. Zusätzlich ist ein Kontaktfeld 94' vorgesehen, welches mit einem seitlichen elektrischen Anschluss 98' verbunden ist. Der verbreiterte Bereich 96 der zentralen Kontaktbahn 92' ist in Längsrichtung im Wesentlichen zwischen den Kontaktfeldern 94 und den Kontaktbahnen 92 angeordnet. Somit kann eine jeweilige Kontaktbahn 92 mit geringem Verdrahtungsaufwand über den ASIC 44 mit einem jeweiligen elektrischen Anschluss 46 elektrisch verbunden werden (Fig. 7). Alternativ kann eine jeweilige Kontaktbahn 92 auch mittels Bonddraht 100 direkt mit einem jeweiligen Kontaktfeld 94 bzw. mit dem betreffenden elektrischen Anschluss 46 verbunden werden (Fig. 8).

Die Trägereinrichtung 12 weist einen Rahmenabschnitt 102 mit mehreren in Querrichtung verlaufenden Trennstegen 104 auf. Der Rahmenabschnitt 102 definiert die Kontaktkammern 38, wobei ein optisches Übersprechen zwischen den Kontaktkammern 38 in horizontaler Richtung unterbunden wird, d.h. der Rahmenabschnitt 102 ist lichtundurchlässig ausgebildet.

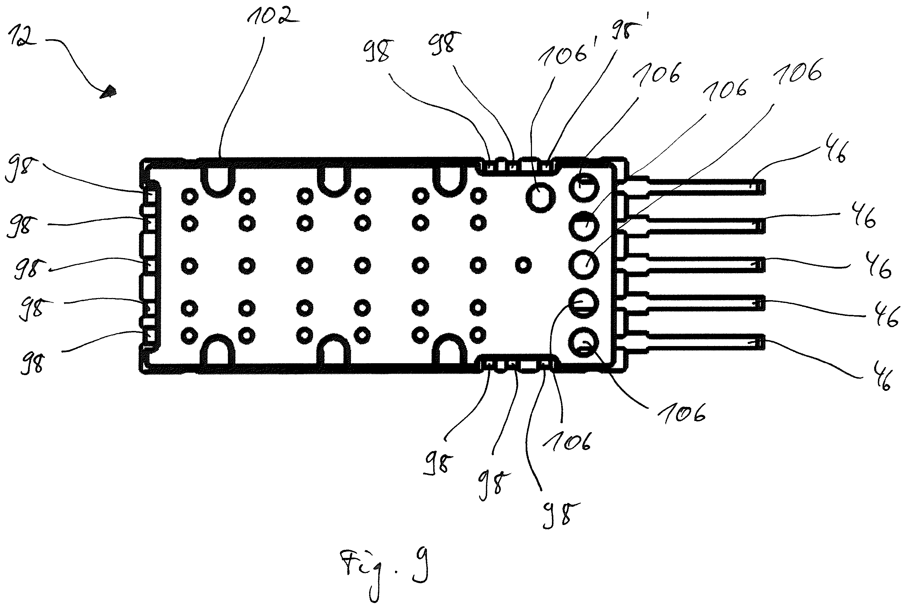

In Fig. 9 ist die Trägereinrichtung 12 in einer Unteransicht gezeigt. An der Unterseite sind mehrere, im Wesentlichen runde Kontaktierungsbereiche 106 für eine jeweilige elektrische Kontaktierung angeordnet. Einer der Kontaktierungsbereiche 106 kann insbesondere als sogenanntes Fuse Pad dienen. Der Kontaktierungsbereich 106' kann mit dem oberseitigen Kontaktfeld 94' elektrisch verbunden sein.

Ein besonderer Vorteil der Trägereinrichtung 12 gemäß den Fig. 7 bis 9 besteht darin, dass die Kontaktkammern 38 in einer variablen Konfiguration hinsichtlich Anzahl und Anordnung mit (opto-) elektronischen Bauelementen 40, 42, 44 bestückt werden können, um eine an eine individuelle Anwendung angepasste optoelektronische Vorrichtung 10 herstellen zu können, wobei auch andere Konfigurationen möglich sind als in den Fig. 7 und 8 gezeigt.

### Bezuqszeichenliste

- 10: optoelektronische Vorrichtung
- 12: Trägereinrichtung
- 14: erstes Aperturelement
- 16: Linsenelement
- 18: Unterteil
- 20: Oberteil bzw. zweites Aperturelement
- 22: Bodenabschnitt
- 24: Seitenteil
- 26: Riegel
- 28: Kammabschnitt
- 30: Aufnahmeraum
- 32: Öffnung
- 34: Rastnasen
- 36: Rastriegel
- 38: Kontaktkammer
- 40: Sender
- 42: Empfänger
- 44: ASIC
- 46: Anschluss
- 48: Vorsprung
- 50: Bereich
- 52: Aperturabschnitt
- 54: Vorsprung
- 56: Bereich
- 58: Rastlasche
- 60: Kodierabschnitt
- 62: erstes Kodierelement
- 63: zweites Kodierelement
- 64: Hohlzylinder
- 66: Ringscheibe
- 68: Linsenabschnitt
- 70: Grundplatte
- 72: Öffnung
- 74: Rastarm
- 76: Zylinder
- 78: Öffnung
- 80: erstes Dekodierelement
- 81: zweites Dekodierelement
- 83: Dekodierabschnitt
- 90: Eingriffsabschnitt
- 92: Kontaktbahn
- 93: Leiterstreifen
- 94: Kontaktfeld
- 96: verbreiteter Bereich
- 98: elektrischer Anschluss
- 100: Bonddraht
- 102: Rahmenabschnitt
- 104: Trennsteg
- 106: Kontaktierungsbereich

## Patentansprüche

1. Trägereinrichtung (12) für eine optoelektronische Vorrichtung (10), wobei die Trägereinrichtung (12) eine Längserstreckung und eine Quererstreckung aufweist,
**dadurch gekennzeichnet,**
**dass** die Trägereinrichtung (12) mehrere parallel zu der Längserstreckung ausgerichtete elektrisch leitende Kontaktbahnen (92) aufweist, und
die Trägereinrichtung (12) an einer Oberseite mehrere parallel zu der Quererstreckung ausgerichtete und optisch voneinander isolierte Kontaktkammern (38) aufweist,
wobei in jeder der mehreren Kontaktkammern (38) jede der mehreren Kontaktbahnen (92) elektrisch kontaktierbar ist, um in einer variablen Bestückung wenigstens einen optoelektronischen Sender (40) und/oder wenigstens einen optoelektronischen Empfänger (42) in der jeweiligen Kontaktkammer (38) installieren zu können,
wobei die Trägereinrichtung (12) drei, vier, fünf oder sechs Kontaktbahnen (92) aufweist,
wobei die Trägereinrichtung (12) einen mit einem Kunststoff umspritzten Leiterrahmen aufweist, der einen segmentierten Leiterstreifen (93) aus Metall umfasst, wobei die elektrisch leitenden Kontaktbahnen (92) an dem segmentierten Leiterstreifen (93) ausgebildet sind, wobei der segmentierte Leiterstreifen (93) teilweise von einem Rahmenabschnitt (102) aus dem Kunststoff umgeben ist,
wobei der Rahmenabschnitt (102) parallel zu der Quererstreckung der Trägereinrichtung (12) verlaufende Trennstege (104) umfasst und an einer Oberseite des Leiterstreifens (93) die mehreren Kontaktkammern (38) definiert, wobei die Kontaktkammern (38) durch die Trennstege (104) voneinander getrennt sind,
und wobei der Rahmenabschnitt (102) aus einem lichtundurchlässigen Material gebildet oder zumindest abschnittsweise mit einer lichtundurchlässigen Schicht überzogen ist.

2. Trägereinrichtung (12) nach Anspruch 1,
wobei die Trägereinrichtung (12) drei, vier, fünf oder sechs Kontaktkammern (38) aufweist.

3. Trägereinrichtung (12) nach Anspruch 1 oder 2,
wobei die Anzahl der Kontaktbahnen (92) der Anzahl der Kontaktkammern (38) entspricht oder sich höchstens um die Anzahl Eins unterscheidet.

4. Trägereinrichtung (12) nach zumindest einem der vorhergehenden Ansprüche,
wobei der Leiterstreifen (93) wenigstens einen elektrischen Anschluss (46, 98) für eine jeweilige Kontaktbahn (92) bildet.

5. Trägereinrichtung (12) nach Anspruch 4,
wobei der wenigstens eine elektrische Anschluss (46) eine elastische Kontaktzunge bildet.

6. Trägereinrichtung (12) nach Anspruch 4 oder 5,
wobei der Leiterstreifen (93) mehrere elektrische Anschlüsse (46, 98) bildet.

7. Trägereinrichtung (12) nach Anspruch 6,
wobei die mehreren elektrischen Anschlüsse (46) zusammen eine Kontaktierungszone für einen elektrischen Steckverbinder bilden.

8. Trägereinrichtung (12) nach Anspruch 6 oder 7,
wobei wenigstens einer der mehreren elektrischen Anschlüsse (46) von den mehreren Kontaktbahnen (92) elektrisch isoliert ist.

9. Trägereinrichtung (12) nach zumindest einem der Ansprüche 6 bis 8, wobei wenigstens einer der mehreren elektrischen Anschlüsse (46) integral mit einer der mehreren Kontaktbahnen (92) ausgebildet ist.

10. Trägereinrichtung (12) nach zumindest einem der vorherigen Ansprüche, wobei eine Installationskontaktbahn (92') der mehreren Kontaktbahnen (92) relativ zu den anderen der mehreren Kontaktbahnen (92) breiter ausgebildet ist.

11. Trägereinrichtung (12) nach Anspruch 10,
wobei die Installationskontaktbahn (92') einen vergrößerten Bereich (96) zum Aufnehmen einer anwendungsspezifischen integrierten Schaltung (44) aufweist.

12. Trägereinrichtung (12) nach zumindest einem der vorhergehenden Ansprüche,
wobei eine Unterseite der Trägereinrichtung (12) wenigstens einen Kontaktierungsbereich (106) aufweist, in dem eine jeweilige der mehreren Kontaktbahnen (92) für eine elektrische Kontaktierung freiliegt.

13. Optoelektronische Vorrichtung (10) mit einer Trägereinrichtung (12) nach zumindest einem der vorhergehenden Ansprüche,
wobei die optoelektronische Vorrichtung (10) ferner ein Linsenelement (16) und eine Halteeinrichtung aufweist, wobei das Linsenelement (16) oberhalb der Trägereinrichtung (12) vorgesehen ist und wenigstens einen Linsenabschnitt (68) für den wenigstens einen optoelektronischen Sender (40) und/oder den wenigstens einen optoelektronischen Empfänger (42) aufweist, und wobei die Halteeinrichtung die Trägereinrichtung (12) und das Linsenelement (16) relativ zueinander hält.

14. System mit mehreren optoelektronischen Vorrichtungen (10) nach Anspruch 13,
wobei die Kontaktkammern (38) zumindest einiger der mehreren optoelektronischen Vorrichtungen (10) in unterschiedlichen Konfigurationen mit jeweils wenigstens einem optoelektronischen Sender (40) und/oder wenigstens einem optoelektronischen Empfänger (42) bestückt sind.

15. System nach Anspruch 14,
wobei jede der mehreren optoelektronischen Vorrichtungen (10) ein Linsenelement (16) aufweist, das oberhalb der Trägereinrichtung (12) vorgesehen ist und wenigstens einen Linsenabschnitt (68) für den wenigstens einen optoelektronischen Sender (40) und/oder den wenigstens einen optoelektronischen Empfänger (42) aufweist, wobei die Linsenelemente (16) von wenigstens einigen der mehreren optoelektronischen Vorrichtungen (10) sich hinsichtlich ihrer jeweiligen Formgebung von den Linsenelementen (16) von anderen der mehreren optoelektronischen Vorrichtungen (10) unterscheiden.

## Claims

1. A carrier device (12) for an optoelectronic apparatus (10),
wherein the carrier device (12) has a longitudinal extent and a transverse extent,
**characterized in that**
the carrier device (12) has a plurality of electrically conductive contact tracks (92) aligned in parallel with the longitudinal extent, and
the carrier device (12) has a plurality of contact chambers (38) at an upper side which are aligned in parallel with the transverse extent and which are optically isolated from one another;
wherein each of the plurality of contact tracks (92) is electrically contactable in each of the plurality of contact chambers (38) to be able to install at least one optoelectronic transmitter (40) and/or at least one optoelectronic receiver (42) in the respective contact chamber (38) in a variable mounting; wherein the carrier device (12) has three, four, five or six contact tracks (92);
wherein the carrier device (12) has a lead frame which is overmolded with a plastic and which comprises a segmented lead strip (93) of metal, wherein the electrically conductive contact tracks (92) are formed at the segmented lead strip (93), wherein the segmented lead strip (93) is at least partly surrounded by a frame section (102) of the plastic;
wherein the frame section (102) comprises partition webs (104) which extend in parallel with the transverse extent of the carrier device (12) and defines the plurality of contact chambers (38) at the upper side of the lead strip (93), wherein the contact chambers (39) are separated from one another by the partition webs (104);
and wherein the frame section (102) is formed from a light-impermeable material or is covered at least sectionally by a light-impermeable layer.

2. A carrier device (12) in accordance with claim 1,
wherein the carrier device (12) has three, four, five or six contact chambers (38).

3. A carrier device (12) in accordance with claim 1 or claim 2,
wherein the number of contact tracks (92) corresponds to the number of contact chambers (38) or differs by at most the number one.

4. A carrier device (12) in accordance with at least one of the preceding claims,
wherein the lead strip (93) forms at least one electrical connector (46, 98) for a respective contact track (92).

5. A carrier device (12) in accordance with claim 4,
wherein the at least one electrical connector (46) forms an elastic contact tongue.

6. A carrier device (12) in accordance with claim 4 or claim 5,
wherein the lead strip (93) forms a plurality of electrical connectors (46, 98).

7. A carrier device (12) in accordance with claim 6,
wherein the plurality of electrical connectors (46) together form a contacting zone for an electrical plug-in connector.

8. A carrier device (12) in accordance with claim 6 or claim 7,
wherein at least one of the plurality of electrical connectors (46) is electrically insulated from the plurality of contact tracks (92).

9. A carrier device (12) in accordance with at least one of the claims 6 to 8, wherein at least one of the plurality of electrical connectors (46) is formed integrally with one of the plurality of contact tracks (92).

10. A carrier device (12) in accordance with at least one of the preceding claims,
wherein an installation contact track (92') of the plurality of contact tracks (92) is wider relative to the other ones of the plurality of contact tracks (92).

11. A carrier device (12) in accordance with claim 10,
wherein the installation contact track (92') has an enlarged region (96) for receiving an application-specific integrated circuit (44).

12. A carrier device (12) in accordance with at least one of the preceding claims,
wherein a lower side of the carrier device (12) has at least one contacting region (106) in which a respective one of the plurality of contact tracks (92) is exposed for an electrical contacting.

13. An optoelectronic apparatus (10) comprising a carrier device (12) in accordance with at least one of the preceding claims,
wherein the optoelectronic apparatus (10) furthermore has a lens element (16) and a holding device; wherein the lens element (16) is provided above the carrier device (12) and has at least one lens section (68) for the at least one optoelectronic transmitter (40) and/or for the at least one optoelectronic receiver (42); and wherein the holding device holds the carrier device (12) and the lens element (16) relative to one another.

14. A system comprising a plurality of optoelectronic apparatus (10) in accordance with claim 13,
wherein the contact chambers (38) of at least some of the plurality of optoelectronic apparatus (10) are equipped in different configurations with a respective at least one optoelectronic transmitter (40) and/or at least one optoelectronic receiver (42).

15. A system in accordance with claim 14,
wherein each of the plurality of optoelectronic apparatus (10) has a lens element (16) which is provided above the carrier device (12) and which has at least one lens section (68) for the at least one optoelectronic transmitter (40) and/or for the at least one optoelectronic receiver (42), with the lens elements (16) of at least some of the plurality of optoelectronic apparatus (10) differing with respect to their respective shapes from the lens elements (16) of other ones of the plurality of optoelectronic apparatus (10).

## Revendications

1. Moyen de support (12) pour un dispositif optoélectronique (10),
le moyen de support (12) présentant une extension longitudinale et une extension transversale,
**caractérisé en ce que**
le moyen de support (12) comprend plusieurs pistes de contact (92) électriquement conductrices, orientées parallèlement à l'extension longitudinale, et
le moyen de support (12) présente sur une face supérieure plusieurs chambres de contact (38) orientées parallèlement à l'extension transversale et optiquement isolées les unes des autres,
dans chacune desdites plusieurs chambres de contact (38), chacune desdites plusieurs pistes de contact (92) peut être mise en contact électrique afin de pouvoir installer, dans un équipement variable, au moins un émetteur optoélectronique (40) et/ou au moins un récepteur optoélectronique (42) dans la chambre de contact (38) respective,
le moyen de support (12) comporte trois, quatre, cinq ou six pistes de contact (92),
le moyen de support (12) comprend un cadre conducteur surmoulé de matière plastique et comprenant une bande conductrice segmentée (93) en métal, les pistes de contact (92) électriquement conductrices étant réalisées sur la bande conductrice segmentée (93), la bande conductrice segmentée (93) étant entourée partiellement par une portion de cadre (102) en matière plastique,
la portion de cadre (102) comprend des barrettes de séparation (104) s'étendant parallèlement à l'extension transversale du moyen de support (12) et définit, sur une face supérieure de la bande conductrice (93), lesdites plusieurs chambres de contact (38), les chambres de contact (38) étant séparées les unes des autres par les barrettes de séparation (104), et la portion de cadre (102) est réalisée en un matériau opaque ou est au moins localement recouverte d'une couche opaque.

2. Moyen de support (12) selon la revendication 1,
le moyen de support (12) comprenant trois, quatre, cinq ou six chambres de contact (38).

3. Moyen de support (12) selon la revendication 1 ou 2,
dans lequel le nombre de pistes de contact (92) correspond au nombre de chambres de contact (38) ou en diffère au maximum du nombre un.

4. Moyen de support (12) selon l'une au moins des revendications précédentes,
dans lequel la bande conductrice (93) forme au moins une connexion électrique (46, 98) pour une piste de contact respective (92).

5. Moyen de support (12) selon la revendication 4,
dans lequel ladite au moins une connexion électrique (46) forme une languette de contact élastique.

6. Moyen de support (12) selon la revendication 4 ou 5,
dans lequel la bande conductrice (93) forme une plusieurs connexions électriques (46, 98).

7. Moyen de support (12) selon la revendication 6,
dans lequel lesdites plusieurs connexions électriques (46) forment ensemble une zone de mise en contact pour un connecteur électrique à fiche.

8. Moyen de support (12) selon la revendication 6 ou 7,
dans lequel l'une au moins desdites plusieurs connexions électriques (46) est électriquement isolée desdites plusieurs pistes de contact (92).

9. Moyen de support (12) selon l'une au moins des revendications 6 à 8, dans lequel l'une au moins desdites plusieurs connexions électriques (46) est réalisée intégralement avec l'une desdites plusieurs pistes de contact (92).

10. Moyen de support (12) selon l'une au moins des revendications précédentes,
dans lequel une piste de contact d'installation (92') desdites plusieurs pistes de contact (92) est réalisée plus large par rapport aux autres desdites plusieurs pistes de contact (92).

11. Moyen de support (12) selon la revendication 10,
dans lequel la piste de contact d'installation (92') présente une zone agrandie (96) pour recevoir un circuit intégré (44) spécifique à l'application.

12. Moyen de support (12) selon l'une au moins des revendications précédentes,
dans lequel une face inférieure du moyen de support (12) comprend au moins une zone de mise en contact (106) dans laquelle une piste respective parmi lesdites plusieurs pistes de contact (92) est mise à découvert pour une mise en contact électrique.

13. Dispositif optoélectronique (10) comportant un moyen de support (12) selon l'une au moins des revendications précédentes,
dans lequel le dispositif optoélectronique (10) comprend en outre un élément de lentille (16) et un moyen de maintien,
l'élément de lentille (16) est prévu au-dessus du moyen de support (12) et comprend au moins une portion de lentille (68) pour ledit au moins un émetteur optoélectronique (40) et/ou pour ledit au moins un récepteur optoélectronique (42), et
le moyen de maintien maintient le moyen de support (12) et l'élément de lentille (16) l'un par rapport à l'autre.

14. Système comportant plusieurs dispositifs optoélectroniques (10) selon la revendication 13,
dans lequel les chambres de contact (38) de quelques-uns au moins desdits plusieurs dispositifs optoélectroniques (10) sont équipées, dans des configurations différentes, chacune d'au moins un émetteur optoélectronique (40) et/ou d'au moins un récepteur optoélectronique (42).

15. Système selon la revendication 14,
dans lequel chacun desdits plusieurs dispositifs optoélectroniques (10) comprend un élément de lentille (16) prévu au-dessus dudit moyen de support (12) et comprenant au moins une portion de lentille (68) pour ledit au moins un émetteur optoélectronique (40) et/ou pour ledit au moins un récepteur optoélectronique (42),
les éléments de lentille (16) de quelques-uns au moins desdits plusieurs dispositifs optoélectroniques (10) diffèrent des éléments de lentille (16) d'autres desdits plusieurs dispositifs optoélectroniques (10) en ce qui concerne leur conception de forme respective.
